# EUROPÄISCHE PATENTSCHRIFT

(11) **EP 0 580 793 B1**
(45) Veröffentlichungstag und Bekanntmachung des Hinweises auf die Patenterteilung: **28.05.1997**
(21) Anmeldenummer: 92915221.3
(22) Anmeldetag: 08.07.1992
(51) Int. Cl.: H03G 11/02

(54) **AMPLITUDENBEGRENZER**
AMPLITUDE LIMITER
LIMITEUR D'AMPLITUDE

(30) Priorität: 13.02.1992 DE 4204199
(43) Veröffentlichungstag der Anmeldung: 02.02.1994
(73) Patentinhaber: Daimler-Benz Aerospace Aktiengesellschaft, 81663 München (DE)
(72) Erfinder: FELDLE, Heinz-Peter, D-7913 Senden (DE); SCHWEIZER, Bernhard, D-7900 Ulm (DE)
(74) Vertreter: Fröhling, Werner Otto, Dr.
(86) Internationale Anmeldenummer: EP9201535
(87) Internationale Veröffentlichungsnummer: WO9316526

(56) Entgegenhaltungen:
- US-A- 4 371 851
- US-A- 4 930 035
- 1988 IEEE MTT International Microwave Symposium digest, May 25 - 27, 1988, volume 1, IEEE New York US, pages 255 258; D. J. SEYMOUR et al.: "X-Band and Ka Band Monolithic GaAs PIN Diode Variable Attenuation Limiters"

## Beschreibung

Die Erfindung betrifft einen Amplitudenbegrenzer und dessen Verwendung für den Hochfrequenzbereich nach den Oberbegriffen der Patentansprüche 1 und 8.

In vielen Anwendungsfällen der Hochfrequenztechnik, insbesondere bei der Radartechnik oder beim Satellitenfunk, werden einerseits leistungsstarke Hochfrequenz(HF)-Sender und andererseits hochempfindliche Hochfrequenz(HF)-Empfänger in unmittelbarer räumlicher Nähe betrieben. Vielfach werden HF-Sender und HF-Empfänger sogar über eine gemeinsame Sende-/Empfangsantenne im Zeitmultiplex betrieben. Dieses ist beispielsweise der Fall bei aktiven phasengesteuerten Antennengruppen (phased-array-antennas), bei denen beispielsweise bis zu mehreren tausend Einzelantennen (Sende(S)- und Empfangs(E)- Antennen) zu einer Antennengruppe zusammengefaßt sind. Mit einer solchen Antennengruppe ist eine Schwenkung der Antennenkeule dadurch möglich, daß an den Einzelantennen einstellbare Phasenschieber für die zu sendende oder zu empfangende HF-Signale vorhanden sind. Bei solchen beispielhaft erwähnten Anordnungen besitzen also sogenannte Sende(S)-, Empfangs(E)- oder Sende-/Empfangs(S/E)-Module eine sehr wichtige Funktion. Es ist vielfach zweckmäßig solche Module als räumlich möglichst kleine Einheit aufzubauen, z.B. für eine phasengesteuerte Antennengruppe für die Nase eines Flugzeuges.

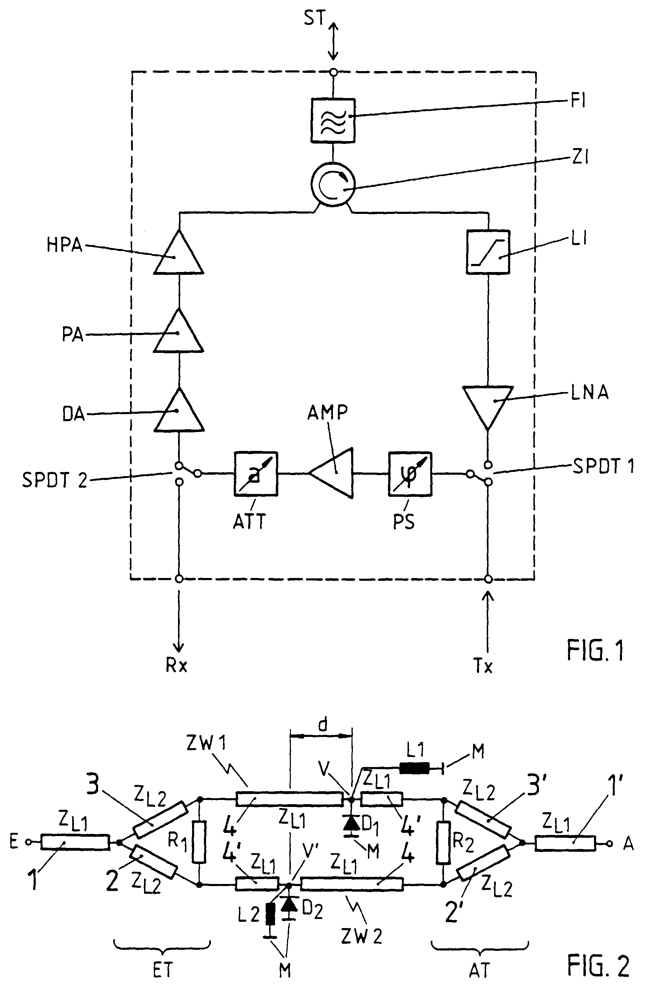

Ein beispielhafter HF-mäßiger Aufbau eines solchen S/E-Moduls ist in FIG. 1 dargestellt. Dieser besteht im wesentlichen aus
- einem Empfangspfad
- einem Sendepfad
- einem gemeinsamen Steuerpfad und
- einem gemeinsamen Strahlerpfad.

Der gemeinsame Strahlerpfad besteht aus einem Strahler ST, einem Filter FI und einer Sende-/Empfangsweiche, z.B. einem Zirkulator ZI.

Der Empfangspfad enthält einen Amplitudenbegrenzer LI für das zu empfangende HF-Signal und einen nachgeschalteten rauscharmen hochempfindlichen Verstärker LNA.

Der Sendepfad enthält einen oder eine Reihenschaltung mehrerer Verstärker für das zu sendende HF-Signal, z.B. nämlich einen Treiber-Verstärker DA, einen Leistungs-Verstärker PA und einen Hochleistungs-Verstärker HPA.

Der gemeinsame Steuerpfad besteht aus einer Reihenschaltung von einem Phasenschieber PS, einem HF-Verstärker AMP und einem HF-Abschwächer ATT.

Ein zu sendendes HF-Signal Tx gelangt über einen ersten Schalter SPDT1, den Steuerpfad, einen zweiten Schalter SPDT2, den Sendepfad und den Strahlerpfad an den Strahler ST, z.B. einen Hornstrahler.

Ein von dem Strahler ST empfangenes HF-Signal gelangt über den Strahlerpfad, den Empfangspfad, den ersten Schalter SPDT1, den Steuerpfad und den zweiten Schalter SPDT2 an einen Ausgang und liegt dort als verstärktes Empfangssignal Rx vor und kann weiterverarbeitet werden.

Sende(S)- oder Empfangs(E)-Module können durch Weglassen des Empfangs- bzw. des Sendepfades hergestellt werden.

Es ist ersichtlich, daß bei solchen Anordnungen im Empfangspfad der dort vorhandene hochempfindliche rauscharme Verstärker LNA besonders geschützt werden muß vor Eingangssignalen mit zu großen Amplituden, die zu einer Zerstörung oder Übersteuerung des Verstärkers LNA führen würden. Solche unzulässig großen Amplituden können im Empfangspfad beispielsweise bei einem defekten Zirkulator ZI auftreten, wodurch das verstärkte Sendesignal unmittelbar in den Empfangspfad gekoppelt würde. Außerdem kann der Strahler ST ein HF-Signal mit einer unzulässig hohen Amplitude empfangen, z.B. infolge eines Blitzeinschlages oder eines unmittelbar vor dem Strahler angeordneten HF-Reflektors. Es ist daher naheliegend, den Verstärker LNA zu schützen durch einen diesem vorgeschalteten Amplitudenbegrenzer LI. Dieser muß eine möglichst geringe (Einfügungs-)Dämpfung besitzen, damit das Empfangssignal möglichst wenig abgeschächt wird und damit die Rauschzahl des S/E-Moduls im Empfangsfall möglichst gering bleibt.

Aus diesem Grunde werden daher reflektierende Amplitudenbegrenzer verwendet. Diese bewirken beim Überschreiten eines maximal zulässigen HF-Schwellenpegels einen HF-mäßigen Kurzschluß. Dadurch wird die zu hohe HF-Leistung in störender Weise über den niederohmigen Pfad des Zirkulators ZI auf die Ausgangsseite des Sendepfades geleitet und kann diesen schädigen oder sogar zerstören.

Der Erfindung liegt die Aufgabe zugrunde, einen gattungsgemäßen Amplitudenbegrenzer anzugeben, der sowohl für den Empfangspfad als auch für einen möglicherweise vorhandenen Sendepfad einen zuverlässigen Schutz vor unzulässig hohen Amplituden bewirkt, der zuverlässig arbeitet, der einen möglichst geringen Raum beansprucht und der kostengünstig herstellbar ist. Der Erfindung liegt außerdem die Aufgabe zugrunde, vorteilhafte Verwendungen eines solchen Amplitudenbegrenzers anzugeben.

Diese Aufgabe wird gelöst durch die in den kennzeichnenden Teilen der Patentansprüche 1 und 8 angegebenen Merkmale. Vorteilhafte Ausgestaltungen und/oder Weiterbildungen sind in den Unteransprüchen zusammengefaßt.

Ein erster Vorteil der Erfindung besteht darin, daß im nicht begrenzenden Fall (Normalfall) eine sehr geringe Einfügungsdämpfung für das HF-Empfangssignal vorhanden ist.

Ein zweiter Vorteil besteht darin, daß im begrenzenden Fall die zerstörende HF-Leistung im Amplitudenbegrenzer reflektiert und zumindest so stark absorbiert wird, daß von der reflektierten HF-Leistung keine Zerstörungen mehr hervorgerufen werden können.

Ein dritter Vorteil besteht darin, daß, in Abhängigkeit von der Frequenz des HF-Empfangssignales, ein nahezu vollständiger Aufbau in Streifenleitungstechnik möglich ist. Dadurch ist die Anordnung mechanisch robust, besitzt einen sehr kleinen Raumbedarf und ist sehr kostengünstig herstellbar. Dadurch ist es sogar möglich, den Amplitudenbegrenzer auf dem Trägersubstrat eines S/E-oder E-Moduls zu integrieren. Der Amplitudenbegrenzer muß also nicht notwendigerweise ein diskretes Bauteil sein.

Ein vierter Vorteil besteht darin, daß die Begrenzung nur durch das empfangene HF-Signal hervorgerufen wird. Es sind also keine Steuersignale erforderlich. Der Amplitudenbegrenzer ist in seiner Wirkungsweise daher als rein passives HF-Bauelement zu betrachten.

Ein fünfter Vorteil besteht darin, daß zur Begrenzung lediglich zwei HF-Gleichrichter benötigt werden, welche vorteilhafterweise als Halbleiterdioden ausgebildet sind.

Ein sechster Vorteil besteht darin, daß die HF-Gleichrichter in einfacher Weise mit einer Gleich- und/oder Niederfrequenz-Vorspannung versorgt werden können, sofern dieses erforderlich ist. Dadurch ist es beispielsweise möglich, beide Gleichrichter möglichst genau auf einen vorgegebenen Amplitudenschwellwert einzustellen oder diesen sogar steuer- oder regelbar auszuführen.

Die Erfindung wird im folgenden anhand eines in der FIG. 2 schematisch dargestellten Ausführungsbeispiels näher erläutert. In folgenden beziehen sich alle Wertangaben auf die Wellenlänge λ, welche das HF-Empfangssignal in der Anordnung besitzt. FIG. 2 zeigt die elektrische Schaltung eines Amplitudenbegrenzers, der z.B. in Form einer Mikrostreifenleitungs-Struktur auf einem Keramik- oder Kunststoff-Substrat herstellbar ist. In dem Substrat sind lediglich zwei Durchgangslöcher (via holes) erforderlich, in welche die Halbleiter-Gleichrichter-Dioden D1, D2 eingesetzt und mit der Rückseite des Substrates (HF-Masse) kontaktiert werden. Es können zusätzlich noch zwei weitere Durchgangslöcher erforderlich sein, nämlich dann, wenn die HF-Induktivitäten L1, L2 erforderlich sind, deren ein Anschluß ebenfalls in der dargestellten Weise mit der HF-Masse verbunden ist. Diese HF-Masseanschlüsse können gegebenenfalls durch Gleichspannungs- oder niederfrequente Wechselspannungsanschlüsse ersetzt werden sofern dieses erforderlich ist, beispielsweise bei einer geforderter genau gleichen Einstellung der begrenzenden Amplitudenschwellwerte, die durch die HF-Gleichrichter D1, D2 bestimmt sind. Alle übrigen in FIG. 2 dargestellten elektrischen Bauelemente sind auf einer Oberflächenseite eines Substrates herstellbar, z.B. als geätzte Leiterbahnstrukturen und/oder als Siebdruckschaltungen, insbesondere für die HF-Absorberwiderstände R₁, R₂. Alternativ dazu ist es beispielsweise möglich für die Absorberwiderstände R₁, R₂ sogenannte SMD-Widerstände ("surface mounted devices") zu verwenden und diese auf die dargestellten Leiterstrukturen aufzulöten oder elektrisch leitend aufzukleben. Diese HF-Absorberwiderstände R₁, R₂ verwandeln die reflektierte HF-Leistung in Wärme, was noch näher erläutert wird. Alle übrigen in FIG. 2 dargestellten HF-Bauteile, die mit dem großen Buchstaben Z und einem tiefgestellten Index bezeichnet sind, bestehen aus den beispielhaft erwähnten Mikrostreifenleitungen. Der dargestellte Amplitudenbegrenzer hat an seinem Eingang E und seinem Ausgang A jeweils gleiche Wellenwiderstände von beispielsweise 50Ω, die derzeit in der HF-Technik üblich sind.

Ein an dem Eingang E anliegendes empfangenes HF-Signal wird zunächst einem 1:1-HF-Leistungs-Eingangsteiler ET zugeführt, dann auf zwei parallel geschaltete Zweige ZW1, ZW2 aufgeteilt und anschließend wieder in einem 1:1-HF-Leistungs-Ausgangskombinierer (Teiler) AT zu einem Ausgangssignal kombiniert, das am Ausgang A anliegt. Dieses Ausgangssignal kann nur eine maximale durch die Gleichrichter-Dioden D₁, D₂ vorgebbare HF-Amplitude besitzen. Die Eingangsleitung 1 und die Ausgangsleitung 1' haben jeweils einen Wellenwiderstand Z_{L1} = 50Ω. Das aus der Eingangsleitung 1 kommende Signal gelangt auf den Eingangsteiler ET. Dieser besteht aus zwei Leiterstücken, 2, 3, die jeweils die gleiche Länge 1 = λ/4 und den gleichen Wellenwiderstand Z_{L2} = 70,7Ω besitzen. Die der Eingangsleitung 1 abgewandten Enden des Eingangsteilers ET sind durch den ohmschen Widerstand R₁ = 100Ω überbrückt. Die an den Eingangsteiler ET anschließenden Zweige ZW1, ZW2 enthalten jeweils eine Hintereinanderschaltung zweier ungleich langer Leitungsstücke 4,4', die alle einen Wellenwiderstand von Z_{L1} = 50Ω besitzen. In jedem Zweig ist die Gesamtlänge der Leitungsstücke 4,4' unwesentlich länger als λ/4. Die Leitungstücke 4,4' sind in den Zweigen ZW1, ZW2 antiparallel geschaltet, daß heißt, bezogen auf den Eingangsteiler ET ist in dem ersten Zweig ZW1 eine Hintereinanderschaltung aus langen Leiterstück 4 und kurzem Leiterstück 4' vorhanden, während in dem zweiten Zweig ZW2 eine Hintereinanderschaltung von dem kurzen Leiterstück 4' und dem langen Leiterstück 4 besteht.

Die Verbindungspunkte V, V' haben einen Abstand d = λ/4. Zwischen den Verbindungspunkten V, V' und der HF-Masse M ist jeweils eine Begrenzerdiode D₁ bzw. D₂ geschaltet und wahlweise parallel dazu jeweils eine Induktivität L1 bzw. L2. Diese Induktivitäten sind vorteilhafterweise als geätzte sogenannte Spiralinduktivitäten ausgeführt und sind so bemessen, daß ein Abfließen des HF-Stromes zur HF-Masse M vermieden wird. Der Ausgangskombinierer AT besitzt den gleichen Aufbau wie der Eingangsteiler ET. Es ist lediglich eine spiegelsymmetrische Anordnung der Bauelemente vorhanden.

Hat nun im normalen Betriebsfall das am Eingang E anliegende HF-Empfangssignal einen Pegel, der unterhalb dem durch die Begrenzerdioden D₁, D₂ einstellbaren maximal zulässigem Pegel liegt, so sind die Begrenzerdioden D₁, D₂ HF-mäßig gesperrt und besitzen daher eine hohe HF-Impedanz. Die in FIG. 2 dargestellte Anordnung ist dann ein einem normalen 50Ω-HF-Leiterstück vergleichbares Bauelement, das eine geringe Einfügungsdämpfung, z.B. kleiner 0,3 dB, besitzt und eine gute HF-mäßige Ein- und Ausgangsimpedanz. Dabei sind die Abweichungen von einem beispielhaft verwendeten Wellenwiderstand von 50Ω zum Beispiel kleiner als 7 %. Daraus ergibt sich vorteilhafterweise für den normalen Betriebsfall eine vernachlässigbare Verschlechterung der Rauschzahl im Empfangspfad und eine vernachlässigbare Änderung der Phase des empfangenen HF-Signales.

Hat nun im Begrenzungsfall das am Eingang E anliegende HF-Empfangssignal einen Pegel, der größer gleich ist dem durch die Begrenzerdioden D₁, D₂ eingestellten maximal zulässigen Pegel, so werden die Begrenzerdioden D₁, D₂ HF-mäßig leitend und bilden einen HF-Kurzschluß zwischen den Verbindungspunkten V, V' und der HF-Masse M. Dadurch werden die von Eingang kommenden und auf die Zweige ZW1, ZW2 aufgespalteten HF-Signale an den Begrenzerdioden D₁, D₂ reflektiert, es ist also ein Reflexionskoeffizient r=-1 vorhanden. Infolge des erwähnten Abstandes d = λ/4 der Begrenzerdioden D₁, D₂ entsteht nun im ersten Zweig ZW1 ein Signalweglängeunterschied L = 2·λ/4 = λ/2. Dadurch werden die reflektierten Signalanteile in dem Absorberwiderstand R₁ in thermische Verlustleistung (Wärme) umgesetzt.

Bei dem beschriebenen Begrenzungsfall entsteht an den Verbindungspunkten V, V' ein Gleichstrom und/oder ein niederfrequenter Strom. Diese störenden Ströme werden über die Induktivitäten L1, L2 an die HF-Masse M abgeleitet. Alternativ dazu ist es möglich, diesen HF-Masseanschluß der Induktivitäten L1, L2 durch einen niederohmigen Gleichspannungsanschluß zu ersetzen. Durch eine derartige Vorspannung kann der Begrenzerdioden D₁, D₂ kann der maximal zulässige Pegel geändert werden. Es ist sogar dessen Steuerung oder Regelung möglich. Es ist insbesondere vorteilhafterweise möglich, die beiden Begrenzerdioden D₁, D₂ auf genau denselben maximal zulässigen HF-Pegel einzustellen, wodurch beispielsweise Fertigungstoleranzen der Begrenzerdioden D₁, D₂ ausgleichbar sind.

Durch diese beschriebenen Eigenschaften wird also der dem Amplitudenbegrenzer nachgeschaltete Verstärker LNA (FIG. 1) zuverlässig gegen unzulässig hohe Signalpegel im Empfangspfad geschützt. Da außerdem die beiden reflektierten HF-Signalanteile im wesentlichen vollständig an dem Absorberwiderstand R₁ in Wärme umgesetzt werden, erfolgt allenfalls eine vernachlässigbare zustäzliche Belastung der Verstärkerkette im Sendepfad des S/E-Moduls (FIG. 1) über den niederohmigen HF-Pfad der S/E-Weiche (Zirkulator ZI). Der Ausgang des Sendepfades ist somit geschützt. Ein weiterer Vorteil ist, daß die HF-mäßige Anpassung des Amplitudenbegrenzers gemäß FIG. 2 im Begrenzungsfall im wesentlichen konstant bleibt bezogen auf den nichtbegrenzten normalen Betriebsfall. Der maximal zulässige HF-Eingangs-Signalpegel ist wählbar durch Wahl der thermischen Belastbarkeit der Absorberwiderstände R₁, R₂ sowie der maximalen elektrischen Belastbarkeit der Begrenzerdioden D₁, D₂.

Die Erfindung ist nicht auf das beschriebene Ausführungsbeispiel beschränkt, sondern sinngemäß auf weitere anwendbar. Beispielsweise können die in Spiralform geätzten Induktivitäten L1, L2 durch Spulen mit gleicher Induktivität ersetzt werden. Außerdem können die beschriebenen Streifenleitungen durch entsprechende HF-Leitungen, z.B. HF-Kabel, ersetzt werden.

Der symmetrische Aufbau gemäß FIG. 2 ermöglicht es weiterhin den Amplitudenbegrenzer vielfältig einzusetzen, z.B. als HF-Pegelbegrenzer in einer bidirektional betriebenen HF-Übertragungsstrecke. Denn auch durch ein am Ausgang A (FIG. 2) anliegendes HF-Signal mit hohem Pegel führt zum Auslösen eines Begrenzungsfalles. Die Verlustleistung (Wärme) entsteht dann in dem Absorberwiderstand R₂.

## Patentansprüche

1. Amplitudenbegrenzer für den Hochfrequenzbereich, wobei der Amplitudenbegrenzer ein ankommendes Eingangssignal, das eine vorgebbare Amplitudenschwelle überschreitet, reflektiert, dadurch gekennzeichnet,
- daß ein Eingangsleistungsteiler (ET), der ein Eingangssignal in zwei gleichartige elektrisch parallel geschaltete Zweige (ZW1, ZW2) aufspaltet, vorhanden ist,
- daß die Ausgänge der Zweige (ZW1, ZW2) durch einen Ausgangsteiler (AT) zu einem Ausgang (A) zusammengefaßt sind,
- daß zwischen die beiden Enden der Zweige (ZW1, ZW2) jeweils ein Absorberwiderstand (R₁, R₂) geschaltet ist,
- daß jeder der Zweige (Z1, Z2) aus einer Hintereinanderschaltung zweier unterschiedlich langer Leitungsstücke (4, 4') besteht,
- daß zwischen der Verbindungsstelle (V, V') der Leitungsstücke (4, 4') und der Masseleitung (M) ein Hochfrequenz-Gleichrichter (D₁, D₂) geschaltet ist und
- daß die Zweige (ZW1, ZW2) antiparallel geschaltet sind, daß heißt, bezogen auf den Eingangsteiler (ET) ist in einem der Zweige (ZW1) eine Hintereinanderschaltung aus einem langen Leiterstück (4) und einem kurzem Leiterstück (4') vorhanden, während in dem anderen der Zweige (ZW2) eine Hintereinanderschaltung von einem kurzen Leiterstück (4') und einem langen Leiterstück (4) besteht.

2. Amplitudenbegrenzer nach Anspruch 1, dadurch gekennzeichnet, daß zumindest einer der Leistungsteiler (ET, AT) eine y-förmige Struktur aufweist und aus Leiterstücken aufgebaut ist.

3. Amplitudenbegrenzer nach Anspruch 1 oder Anspruch 2, dadurch gekennzeichnet, daß ein Hochfrequenz-Gleichrichter (D₁, D₂) als Halbleiterdiode ausgebildet ist.

4. Amplitudenbegrenzer nach einem der vorhergehenden Ansprüche, dadurch gekennzeichnet, daß der an die Leiterstücke (4, 4') angeschlossene Anschluß des Hochfrequenzgleichrichters (D₁, D₂) über eine die Hochfrequenz sperrende Induktivität (L1, L2) an ein vorgebbares Potential angeschlossen ist.

5. Amplitudenbegrenzer nach einem der vorhergehenden Ansprüche, dadurch gekennzeichnet, daß zumindest die Eingangs- und Ausgangsteiler (ET, AT) sowie die Zweige (ZW1, ZW2) in Streifenleitungstechnik ausgebildet sind.

6. Amplitudenbegrenzer nach einem der vorhergehenden Ansprüche, dadurch gekennzeichnet, daß mindestens ein Absorberwiderstand (R₁, R₂) als gedruckter Widerstand ausgebildet ist.

7. Amplitudenbegrenzer nach einem der vorhergehenden Ansprüche, dadurch gekennzeichnet, daß durch die antiparallele Schaltung der Zweige (ZW1, ZW2) zwischen den HF-Gleichrichtern (D1, D2) ein Abstand(d) von λ/4 entsteht, wobei λ die Wellenlänge des empfangenen HF-Signals bedeutet.

8. Amplitudenbegrenzer nach einem der vorhergehenden Ansprüche, gekennzeichnet zur Verwendung im Eingang einer Empfangsstufe eines HF-Empfängers.

9. Amplitudenbegrenzer nach einem der vorhergehenden Ansprüche, gekennzeichnet zur Verwendung im Eingang eines Empfangspfades eines Sende-/Empfangsmoduls für HF-Signale.

10. Amplitudenbegrenzer nach einem der vorhergehenden Ansprüche, gekennzeichnet zur Verwendung im Eingang einer Empfangsstufe eines Radarempfängers.

## Claims

1. Amplitude limiter for the high frequency range, wherein the amplitude limiter reflects an arriving input signal which exceeds a presettable amplitude threshold, characterised thereby
- that an input power divider (ET), which splits up the input signal into two similar electrical branches (ZW1, ZW2) connected in parallel, is present,
- that the outputs of the branches (ZW1, ZW2) are combined into one output (A) by an output divider (AT),
- that a respective absorber resistance (R₁, R₂) is connected between the two ends of each of the branches (ZW1, ZW2),
- that each of the branches (Z1, Z2) consists of a series connection of two line members (4, 4') of different length,
- that a high frequency rectifier (D₁, D₂) is connected between the connecting point (V, V') of the line members (4, 4') and the ground line (M) and
- that the branches (ZW1, ZW2) are connected in anti-parallel, which means that with respect to the input divider (ET) a series connection of a long line member (4) and a short line member (4') is present in one of the branches (ZW1), while a series connection of a short line member (4') and a long line member (4) exists in the other of the branches (ZW2).

2. Amplitude limiter according to claim 1, characterised thereby that at least one of the power dividers (ET, AT) has a y-shaped structure and is constructed from line members.

3. Amplitude limiter according to claim 1 or claim 2, characterised thereby that a high frequency rectifier (D₁, D₂) is constructed as a semiconductor diode.

4. Amplitude limiter according to one of the preceding claims, characterised thereby that the terminal, which is connected to the line members (4, 4'), of the high frequency rectifier (D₁, D₂) is connected to a presettable potential by way of an inductance (L1, L2) blocking the high frequency.

5. Amplitude limiter according to one of the preceding claims, characterised thereby that at least the input divider and output divider (ET, AT) as well as the branches (ZW1, ZW2) are constructed in strip conductor technique.

6. Amplitude limiter according to one of the preceding claims, characterised thereby that at least one absorber resistance (R₁, R₂) is constructed as a printed resistor.

7. Amplitude limiter according to one of the preceding claims, characterised thereby that a spacing (d) of λ/4 arises between the high frequency rectifiers (D1, D2) due to the antiparallel connection of the branches (ZW1, ZW2), wherein λ signifies the wavelength of the received high frequency signal.

8. Amplitude limiter according to one of the preceding claims, characterised by use in the input of a receiving stage of a high frequency receiver.

9. Amplitude limiter according to one of the preceding claims, characterised by use in the input of a receiving path of a transmitter-receiver module for high frequency signals.

10. Amplitude limiter according to one of the preceding claims, characterised by use in the input of a receiving stage of a radar receiver.

## Revendications

1. Limiteur d'amplitude pour le domaine haute fréquence, dans lequel, un signal d'entrée arrivant, qui dépasse un seuil d'amplitude prédéterminé, est réfléchi, caractérisé en ce que :
- un diviseur de puissance d'entrée (ET) est prévu, qui divise un signal d'entrée en deux dérivations (ZW1, ZW2) identiques montées en parallèle électriquement,
- les sorties des dérivations (ZW1, ZW2) sont réunies par un diviseur de sortie (AT) en une sortie (A),
- entre les deux extrémités des dérivations (ZW1, ZW2) est montée une résistance d'absorbeur (R₁, R₂),
- chacune des dérivations (Z1, Z2) se compose d'un montage en série de deux tronçons conducteurs (4, 4') de longueur différente,
- entre les points de liaison (V, V') des tronçons conducteurs (4, 4') et la ligne de masse (M) est monté un redresseur haute fréquence (D1, D2) et
- les dérivations (ZW1, ZW2) sont montées en anti-parallèle, c'est-à-dire que par rapport au diviseur d'entrée (ET) est prévu, dans l'une des dérivations (ZW1), un montage série d'un tronçon, conducteur long (4) et d'un tronçon conducteur court (4'), tandis que dans l'autre des dérivations (ZW2) est prévu un montage série d'un tronçon conducteur court (4') et d'un tronçon conducteur long (4).

2. Limiteur d'amplitude selon la revendication 1, caractérisé en ce qu'au moins un des diviseurs de puissance (ET, AT) présente une structure en y et se compose de tronçons conducteurs.

3. Limiteur d'amplitude selon la revendication 1 ou la revendication 2, caractérisé en ce qu'un redresseur haute fréquence (D₁, D₂) est réalisé en tant que diode semiconductrice.

4. Limiteur d'amplitude selon l'une des revendications précédentes, caractérisé en ce que la borne reliée aux tronçons conducteurs (4, 4') du redresseur à haute fréquence (D₁, D₂) est reliée par l'intermédiaire d'un inductance (L1, L2) bloquant la haute fréquence à un potentiel prédéterminé.

5. Limiteur d'amplitude selon l'une des revendications précédentes, caractérisé en ce qu'au moins le diviseur d'entrée et de sortie (ET, AT) ainsi que les dérivations (ZW1, ZW2) sont réalisés selon la technique à conducteurs en bandes.

6. Limiteur d'amplitude selon l'une des revendications précédentes, caractérisé en ce qu'au moins une résistance d'absorbeur (R₁, R₂) est réalisée sous la forme d'une résistance imprimée.

7. Limiteur d'amplitude selon l'une des revendications précédentes, caractérisé en ce que par le montage anti-parallèle des des dérivations (ZW1, ZW2) entre les redresseurs HF (D1, D2) est obtenu un écartement (d) de λ/4, λ représentant la longueur d'onde du signal HF reçu.

8. Limiteur d'amplitude selon l'une des revendications précédentes, caractérisé pour l'utilisation à l'entrée d'un étage de réception d'un récepteur HF.

9. Limiteur d'amplitude selon l'une des revendications précédentes, caractérisé pour l'utilisation à l'entrée d'un trajet de réception d'un module d'émission/réception pour des signaux HF.

10. Limiteur d'amplitude selon l'une des revendications précédentes, caractérisé pour l'utilisation à l'entrée d'un étage de réception d'un récepteur radar.
